# EUROPÄISCHE PATENTANMELDUNG

(11) **EP 0 700 153 A2**
(43) Veröffentlichungstag der Anmeldung: **06.03.1996**
(21) Anmeldenummer: 95202283.8
(22) Anmeldetag: 23.08.1995
(51) Int. Cl.: H03G 5/02

(54) **Schaltungsanordnung mit steuerbarem Übertragungsverhalten**

(30) Priorität: 03.09.1994 DE 4431481
(71) Anmelder: Philips Patentverwaltung GmbH, D-22335 Hamburg (DE); Philips Electronics N.V., NL-5621 BA Eindhoven (NL)
(72) Erfinder: Kilian, Ernst-August, c/o Philips, D-22335 Hamburg (DE); Möller, Christoph, c/o Philips, D-22335 Hamburg (DE)
(74) Vertreter: Peters, Carl Heinrich, Dipl.-Ing.

(57) **Zusammenfassung**

Beschrieben wird eine Schaltungsanordnung mit steuerbarem Übertragungsverhalten zwischen einem Signaleingang (2) und einem Signalausgang (5) für ein Signal innerhalb eines vorgebbaren Übertragungs-Frequenzbereichs, mit einer Tiefenstellerstufe (1), der das Signal vom Signaleingang (2) zum einstellbaren Anheben des Amplituden-Frequenzgangs des Signals bei tiefen Frequenzen des Übertragungs-Frequenzbereichs zuführbar ist.

In einer derartigen Schaltungsanordnung wird bei Reduzierung des konstruktiven Aufwandes ein flexibler Einsatz und ein verbessertes Übertragungsverhalten erzielt durch eine Kerbfilterstufe (3), der das in der Tiefenstellerstufe (1) bearbeitete Signal zuleitbar ist zum von der Tiefenstellerstufe (1) unabhängig einstellbaren Absenken des Amplituden-Frequenzgangs des Signals bei mittleren Frequenzen des Übertragungs-Frequenzbereichs und durch die das von ihr bearbeitete Signal dem Signalausgang zuführbar ist.

## Beschreibung

Die Erfindung bezieht sich auf eine Schaltungsanordnung mit steuerbarem Übertragungsverhalten zwischen einem Signaleingang und einem Signalausgang für ein Signal innerhalb eines vorgebbaren Übertragungs-Frequenzbereichs, mit einer Tiefenstellerstufe, der das Signal vom Signaleingang zum einstellbaren Anheben des Amplituden-Frequenzgangs des Signals bei tiefen Frequenzen des Übertragungs-Frequenzbereichs zuführbar ist.

Aus der DE-PS 31 32 402 ist eine Schaltungsanordnung mit elektronisch steuerbarem Übertragungsverhalten bekannt, in der das Eingangssignal einem Verstärker mit steuerbarer Gegenkopplung zugeführt wird, an dessen Ausgang eine Spannungsteileranordnung angeschlossen ist. Diese Spannungsteileranordnung ist mit mehreren Abgriffen versehen, die über einen ersten elektronisch steuerbaren Umschalter mit einem invertierenden Eingang des Verstärkers und über einen zweiten elektronisch steuerbaren Umschalter mit dem Ausgang der Schaltung verbunden sind. Dabei kann die Spannungsteileranordnung einen frequenzabhängigen Übertragungsfaktor haben, so daß die Schaltungsanordnung als Höhensteller oder als Tiefensteller verwendet werden kann. Mit einer solchen Schaltung kann ein Klangsteller für die Übertragung eines Tonsignals aufgebaut werden.

Aus der EP-PS 91 160 ist eine Signalverstärkungs- und/oder Dämpfungsschaltung mit einem Eingang für den Empfang eines Eingangssignals und einem Ausgang für die Ausgabe eines Ausgangssignals bekannt. Diese Schaltung besteht weiter aus einer Verstärkerstufe mit einem invertierenden Eingang, mit einem nicht invertierenden Eingang und mit einem Ausgang in Verbindung mit dem Schaltungsausgang, ferner aus einem ersten Spannungsteiler mit wenigstens zwei Anzapfungen, der zwischen dem Schaltungseingang und einem ersten Verbindungsanschluß der Schaltung angeordnet ist und dessen Anzapfungen an eine erste steuerbare Schalteinheit zum Verbinden einzelner dieser Anzapfungen mit dem nicht invertierenden Eingang angeschlossen sind, und einem steuerbaren Gegenkopplungsweg vom Schaltungsausgang zum invertierenden Eingang mit einem zweiten Spannungsteiler mit wenigstens zwei Anzapfungen, der zwischen dem Schaltungsausgang und einem zweiten Verbindungsanschluß angeordnet ist und dessen Anzapfungen an eine zweite Schalteinheit zum Verbinden einzelner dieser Anzapfungen an den invertierenden Eingang des Verstärkers angeschlossen sind. Dabei sind die ersten und zweiten Verbindungsanschlüsse an einen Punkt konstanten Potentials, wahlweise über je eine Impedanz, angeschlossen, und ist die Steuerung der ersten Schalteinheit von der Steuerung der zweiten Schalteinheit unabhängig. Mit einer solchen Anordnung kann ein frequenzabhängiger Übertragungsfaktor zwischen dem Eingang und dem Ausgang und somit ebenfalls eine Baßsteuerung oder eine Höhensteuerung geschaffen werden.

Aus der EP-OS 456 321 ist eine Schaltungsanordnung mit elektronisch steuerbarem Übertragungsverhalten bekannt, in der das Eingangssignal einem Vertärker mit steuerbarer Gegenkopplung zugeführt wird, dessen Ausgang eine Spannungsteileranordnung mit frequenzabhängigem Verhalten angeschlossen ist, die mit mehreren Abgriffen versehen ist, die über einen ersten elektronisch steuerbaren Umschalter mit einem invertierenden Eingang des Verstärkers und über einen zweiten elektronisch steuerbaren Umschalter mit einem Ausgang der Schaltung verbunden sind. Zur Beeinflussung der Güte verschiedener erzeugbarer Filterkurven ist vorgesehen, daß die beiden Umschalter so gesteuert sind, daß für eine Anhebung des Eingangssignals in einem von dem frequenzabhängigen Spannungsteiler bestimmten Frequenzbereich der erste Umschalter auf eine solche Position gesetzt wird, daß die Anhebung in der gewünschten Frequenzbereichsbreite erfolgt und daß die Position des zweiten Umschalters so gewählt wird, daß die Anhebung in dem gewünschten Maß erfolgt, und daß für eine Absenkung des Eingangssignals in dem von dem frequenzabhängigen Spannungsteiler bestimmten Frequenzbereich der zweite Umschalter auf eine solche Position gesetzt wird, daß die Absenkung mit der gewünschten Frequenzbereichsbreite erfolgt, und daß der erste Umschalter auf eine solche Position gesetzt wird, daß die Absenkung in dem gewünschten Maße erfolgt. Mit einer solchen Anordnung kann in einem bestimmten Frequenzbereich eine Anhebung oder eine Absenkung der Amplitude eines Signals erhalten werden, ähnlich einer einstellbaren Bandpaß- oder Bandsperrfilterkurve.

Für eine hochwertige, originalgetreue Wiedergabe von Tonsignalen durch elektroakustische Geräte ist die richtige Einstellung des zur eingestellten Lautstärke passenden Amplituden-Frequenzgangs des Tonsignals eine wesentliche Voraussetzung. Hierzu müssen wegen der frequenz- und lautstärkabhängigen Gehörempfindlichkeit die Tiefen und in geringem Maße auch die hohen Tonlagen gegenüber den mittleren mit angehobenem Pegel wiedergegeben werden, und zwar um so mehr, je leiser die Tonwiedergabe eingestellt ist. Dazu ist es bekannt, in Rundfunkempfängern und Hi-Fi-Geräten den Lautstärke-Einsteller derart frequenzabhängig zu machen, daß die Tiefen- und in geringem Maße auch die Höhenanhebung mit kleiner eingestellter Lautstärke zunimmt. Dadurch wird die automatische Anpassung an den Amplituden-Frequenzgang der Kurven gleicher Gehörempfindlichkeit für die jeweils eingestellte Lautstärke angestrebt.

Derartige Maßnahmen bewirken eine Verstärkung der tiefen Frequenzen bei leiser und eine Abschwächung bei lauter Tonwiedergabe und reagieren nur auf Lautstärkeeinstellungen, wobei sie an einen immer gleichen Signalpegel vor dem Lautstärkesteller derart gebunden sind, daß zu gleicher Einstellung stets die gleiche Lautstärke gehört. Dient der Lautstärkesteller gleichzeitig zum Ausgleich der unterschiedlichen Pegel der Signalquellen wie Rundfunk, Tonband, Schallplatte oder dergleichen, dann ist der so eingestellte Frequenzgang mit entsprechenden Fehlern behaftet.

Aus der DE-PS 22 31 647 ist eine Verstärkerschaltungsanordnung für Tonfrequenzen mit einem Hauptkanal und mit einem oder mehreren abzweigenden Kanälen, welche jeweils einen einen Frequenzbereich der Tonfrequenzen durchlassenden Filter enthalten und die entweder vor dem Endverstärker in einem linearen Additionsglied mit dem Hauptkanal zusammengeführt oder über separate Endverstärker jeweils an eigene Lautsprecher angeschlossen sind, bekannt. Dabei ist der Pegel in den abzweigenden Kanälen für die in der Gehörempfindlichkeit benachteiligten Gehörfrequenzbereiche, insbesondere der tiefen, veränderlich anhebbar. Die bekannte Schaltung enthält in mindestens einem der abzweigenden Kanäle eine eigene Dynamik-Kompressionsschaltung, die derart ausgebildet ist, daß der Pegel des Frequenzbandes bei kleiner Lautstärke in Anpassung an die Kurven gleicher Gehörempfindlichkeit angehoben ist und mit größer werdenden Tonstärken die Anhebung im Verhältnis zur Lautstärke nur in geringem Maß zunimmt.

Bei dieser aus der DE-PS 22 31 647 bekannten Verstärkerschaltung wird eine Anordnung benutzt, bei der eine Aufteilung in mehrere, einzelnen Frequenzbereichen zugeordnete Verstärkerkanäle erfolgt, ähnlich den Ausführungen von Tief-, Mittel- und Hochtonlautsprechern, bei denen die Frequenzweichen nicht vor den Lautsprechersystemen angeordnet sind, sondern für jeden Frequenzbereich mit eigenem Lautsprecher ein eigener Endverstärker vorhanden ist, vor dessen Eingang das seinen Bereich durchlassende Filter geschaltet ist.

Eine derartige Schaltungsanordnung stellt einen hohen apparativen Aufwand dar.

Aus der DE-PS 41 14 364 ist eine Vorrichtung zur gehörrichtigen Lautstärkesteuerung bekannt, durch die die digitale Steuerung eines analogen Audiosignals durch dessen Dämpfung ermöglicht werden soll. Diese Anordnung enthält eine Widerstandsteilereinrichtung mit einer Korrekturimpedanz. Die Widerstandsteilereinrichtung ist zur digitalen Steuerbarkeit mit mindestens zwei feinstufigen Widerstandsketten und einer grobstufigen Widerstandskette ausgeführt. Zur Widerstandskette ist eine Abgriffsauswahleinrichtung vorhanden. Auch diese Anordnung stellt einen sehr hohen apparativen Aufwand dar, wobei nur eine sehr eingeschränkte Art der Lautstärkesteuerung möglich ist.

Aus dem Aufsatz "Integrierte Lautstärke- und Klangeinsteller A273 und A274", erschienen in der Zeitschrift "Radio Fernsehen Elektronik" 28. Jahrgang, Heft 12, 1979, Seiten 751 bis 757, ist eine Schaltungsanordnung zur gehörrichtigen Lautstärkebeeinflussung bekannt. Diese enthält ein elektronisches Potentiometer und einen nachfolgenden Verstärker. Diese Schaltungsteile werden wiederum von einer Ansteuerschaltung geschaltet. Die gehörrichtige Lautstärkebeeinflussung wird durch die Anordnung eines T-Gliedes im Gegenkopplungszweig des Verstärkers mit dem elektronischen Potentiometer erreicht. Die Steuerspannung für dieses Potentiometer ist verknüpft mit der Lautstärkesteuerspannung, dadurch ergibt sich abhängig von der Größe der Lautstärkesteuerspannung eine unterschiedliche Wirkung der gehörrichtigen Lautstärkekorrektur. Diese kann zusätzlich mit einem Widerstand in der Weise beeinflußt werden, daß der Zusammenhang der gehörrichtigen Lautstärkekorrektur mit der Lautstärkesteuerspannung veränderbar ist. Es läßt sich damit aber allenfalls ein Proportionalitätsfaktor zwischen der Lautstärkesteuerspannung und der Steuerspannung für das elektronische Potentiometer zur gehörrichtigen Lautstärkebeeinflussung verändern. Durch das elektronische Potentiometer wird eine vorgegebene Charakteristik eines Amplituden-Frequenzgangs über den gesamten zu übertragenden Frequenzbereich wahlweise überblendbar in einen Verlauf des Amplituden-Frequenzgangs mit frequenzunabhängiger Amplitude gemacht.

Die im vorgenannten Aufsatz beschriebenen integrierten Schaltungen A273 und A274 sind im übrigen identisch mit den im "Valvo Brief" vom 14.11.1978 bzw. der "Valvo Technische Informationen für die Industrie" 800610 vom 10.06.1980 oder im "Valvo Handbuch Integrierte Schaltungen für Fernseh-, Rundfunk- und NF-Anwendungen 1976", Seiten 249 bis 262, dargestellten integrierten Schaltungen vom Typ TCA 730 bzw. TCA 740 identisch.

Es hat sich gezeigt, daß die bekannten Schaltungen für den Einsatz zur gehörrichtigen Lautstärkeeinstellung mehrere Nachteile aufweisen, die sie insgesamt für einen Einsatz in modernen Tonsignal-Verarbeitungsschaltungen nachteilig erscheinen lassen. Die vorstehend beschriebenen Schaltungsanordnungen sind zu aufwendig aufgebaut und/oder bieten nur eine begrenzte, nicht allen Anforderungen gerecht werdende Einstellung der gehörrichtigen Lautstärkesteuerung. Insbesondere ist keine der bekannten Schaltungsanordnungen in der Lage, eine ideale gehörrichtige Lautstärkesteuerung über den gesamten Frequenzbereich und den gesamten Lautstärkesteuerbereich für beliebige Signalquellen mit entsprechend unterschiedlich vorgegebenen Signalen verschiedener Amplituden-Frequenzgänge mit geringem Schaltungsaufwand zu ermöglichen.

Die Erfindung hat die Aufgabe, eine Schaltungsanordnung zu schaffen, durch die mit geringem Aufwand ein beliebig anpaßbarer Amplituden-Frequenzgang insbesondere für die gehörrichtige Lautstärkesteuerung von Tonsignalen unterschiedlicher Quellen ermöglicht wird.

Diese Aufgabe wird erfindungsgemäß bei einer Schaltungsanordnung der eingangs genannten Art gelöst durch eine Kerbfilterstufe, der das in der Tiefenstellerstufe bearbeitete Signal zuleitbar ist zum von der Tiefenstellerstufe unabhängig einstellbaren Absenken des Amplituden-Frequenzgangs des Signals bei mittleren Frequenzen des Übertragungs-Frequenzbereichs und durch die das von ihr bearbeitete Signal dem Signalausgang zuführbar ist.

Durch die erfindungsgemäße Kombination der Tiefenstellerstufe mit der Kerbfilterstufe und eine voneinander unabhängige Einstellung dieser beiden Stufen auf unterschiedliche Amplituden-Frequenzgänge des Signals bei den durch diese Stufen beeinflußbaren Frequenzen des Übertragungs-Frequenzbereichs wird mit geringem Schaltungsaufwand eine sehr wirksame und flexible Einstellung des gesamten Amplituden-Frequenzgangs insbesondere für eine gehörrichtige Lautstärkewiedergabe erhalten. Insbesondere ist mit geringem Aufwand ein hinreichend steiler Übergang des Amplituden-Frequenzgangs von einer Anhebung von Signalanteilen bei tiefen Frequenzen zu einer Absenkung bei Signalen mittlerer Frequenzen erreichbar. Ein derartig steiler Übergang ist mit Tiefen- bzw. Höhenstellern, die in der durch die eingangs aufgeführte Literatur beschriebenen Weise ausgebildet sind, nicht zu erreichen. Darüber hinaus zeichnet sich die erfindungsgemäße Schaltungsanordnung durch ein besonders niedriges Rauschen aus. Die erfindungsgemäße Schaltungsanordnung ermöglicht somit einen sehr flexiblen Einsatz bei vermindertem Schaltungsaufwand und verbessertem Übertragungsverhalten.

In einer Ausgestaltung der erfindungsgemäßen Schaltungsanordnung ist die Tiefenstellerstufe mit einem Verstärker mit steuerbarer Gegenkopplung ausgebildet, an dessen Ausgang eine erste Spannungsteileranordnung mit frequenzabhängigem Verhalten angeschlossen ist, die mit mehreren Abgriffen versehen ist, die über einen ersten elektronisch steuerbaren Umschalter mit einem invertierenden Eingang des Verstärkers verbindbar sind, wobei ein nicht invertierender Eingang des Verstärkers mit dem Signaleingang der Schaltungsanordnung verbunden ist und dem Ausgang des Verstärkers das Signal mit bei den tiefen Frequenzen angehobenem Amplituden-Frequenzgang entnehmbar ist. Eine derartige Schaltungsanordnung verbindet den Vorteil geringen Aufwandes mit demjenigen einer einfachen digitalen Steuerbarkeit.

Nach einer Fortbildung der erfindungsgemäßen Schaltungsanordnung umfaßt die erste Spannungsteileranordnung eine durch eine Reihenschaltung ohmscher Widerstände gebildete erste Widerstandskette, deren Verbindungs- und Endpunkte die Abgriffe bilden, wobei ein erster der Endpunkte der ersten Widerstandskette mit dem Ausgang des Verstärkers verbunden ist, und ein erstes Netzwerk mit frequenzabhängigem Verhalten, das mit einem ersten Anschluß an einen zweiten der Endpunkte der ersten Widerstandskette, mit einem zweiten Anschluß an den Ausgang des Verstärkers und mit einem dritten Anschluß an Masse angeschlossen ist.

Bei dieser Anordnung wird der grundsätzliche Verlauf des Amplituden-Frequenzgangs durch das erste Netzwerk bestimmt und kann durch Änderungen in diesem Netzwerk einfach an unterschiedliche Anforderungen angepaßt werden. Durch die über die Abgriffe der ersten Spannungsteileranordnung, d.h. der ersten Widerstandskette, variabel zuschaltbare Gegenkopplung des Verstärkers kann dieser grundsätzliche Amplituden-Frequenzgang stärker oder schwächer ausgebildet werden. Für die Dimensionierung der Tiefenstellerstufe ergibt sich der Vorteil, daß das erste Netzwerk einerseits und die erste Widerstandskette andererseits unabhängig voneinander bemessen werden können. Vorzugsweise kann die erste Widerstandskette mit dem ersten Umschalter und dem Verstärker in einem integrierten Baustein zusammengefaßt werden, dem ein dem jeweiligen Verwendungszweck leicht anpaßbares Netzwerk nach Bedarf extern hinzugefügt wird.

In entsprechender Ausbildung der erfindungsgemäßen Schaltungsanordnung umfaßt die Kerbfilterstufe eine zweite Spannungsteileranordnung mit frequenzabhängigem Verhalten, die mit mehreren Abgriffen versehen ist, die über einen zweiten elektronisch steuerbaren Umschalter mit dem Signalausgang der Schaltungsanordnung verbindbar sind, wobei einem Endanschluß der zweiten Spannungsteileranordnung das Signal von der Tiefenstellerstufe zuführbar ist. Dabei umfaßt die zweite Spannungsteileranordnung insbesondere eine durch eine Reihenschaltung ohmscher Widerstände gebildete zweite Widerstandskette, deren Verbindungs- und Endpunkte die Abgriffe bilden, wobei ein erster der Endpunkte der zweiten Widerstandskette mit dem Endanschluß der zweiten Spannungsteileranordnung, dem das Signal von der Tiefenstellerstufe zuführbar ist, verbunden ist, und ein zweites Netzwerk mit frequenzabhängigem Verhalten, das mit einem ersten Anschluß an den ersten Endpunkt der zweiten Widerstandskette, mit einem zweiten Anschluß an einen zweiten der Endpunkte der zweiten Widerstandskette und mit einem dritten Anschluß an Masse angeschlossen ist.

Dadurch, daß die beschriebenen Umschalter voneinander unabhängig gesteuert werden, vorteilhaft durch eine entsprechend ausgebildete Steuerschaltung mit Hilfe digitaler Steuersignale, kann ein in sehr weiten Grenzen veränderbarer Amplituden-Frequenzgang eingestellt werden, der praktisch allen Anforderungen unterschiedlicher Signalquellen gerecht werden kann. Bei einem Einsatz zur gehörrichtigen Lautstärkesteuerung kann dabei zu jeder Lautstärkeeinstellung, zu jeder Signalquelle und zu jedem in der Praxis verfügbaren Aufbau zur Signalverarbeitung und Umwandlung in Schallwellen ein Amplituden-Frequenzgang vorgegeben werden, der dem gewünschten Höreindruck exakt entspricht.

Vorzugsweise ist ergänzend zu den beschriebenen Stufen ein dritter Umschalter vorgesehen, der einen Ausgang aufweist, der mit dem Signalausgang der Schaltungsanordnung verbunden ist, und der weiterhin zwei Eingänge aufweist, die wahlweise mit dem Ausgang des Umschalters verbindbar sind, wobei dem ersten dieser Eingänge das Signal vom Signaleingang der Schaltungsanordnung und dem zweiten dieser Eingänge das Signal von der Kerbfilterstufe zuleitbar ist.

Durch diesen Umschalter kann die erfindungsgemäße Schaltungsanordnung je nach erwünschtem Signalübertragungsverhalten in einen Signalweg zugeschaltet oder aus ihm abgeschaltet werden, wobei im letztgenannten Fall eine frequenzunabhängige Übertragung erhalten wird.

Weitere vorteilhafte Ausgestaltungen der Erfindung sind in den Unteransprüchen beschrieben.

Die Zeichnung, in deren unterschiedlichen Figuren miteinander übereinstimmende Elemente dieselben Bezugszeichen tragen, sind einige Ausführungsbeispiele der Erfindung dargestellt. Es zeigen
Fig. 1 ein erstes Ausführungsbeispiel der erfindungsgemäßen Schaltungsanordnung,
Fig. 2 eine Abwandlung zu Fig. 1 für ein zweites Ausführungsbeispiel der erfindungsgemäßen Schaltungsanordnung,
Fig. 3 ein Diagramm zum Amplituden-Frequenzgang der Schaltungsanordnung nach Fig. 1,
Fig. 4 ein weiteres Diagramm zu den Amplituden-Frequenzgängen der Schaltungsanordnungen nach den Fig. 1 und 2,
Fig. 5, 6 und 7 Diagramme zu den Amplituden-Frequenzgängen der Schaltungsanordnung nach Fig. 1 für verschiedene Betriebsbeispiele.

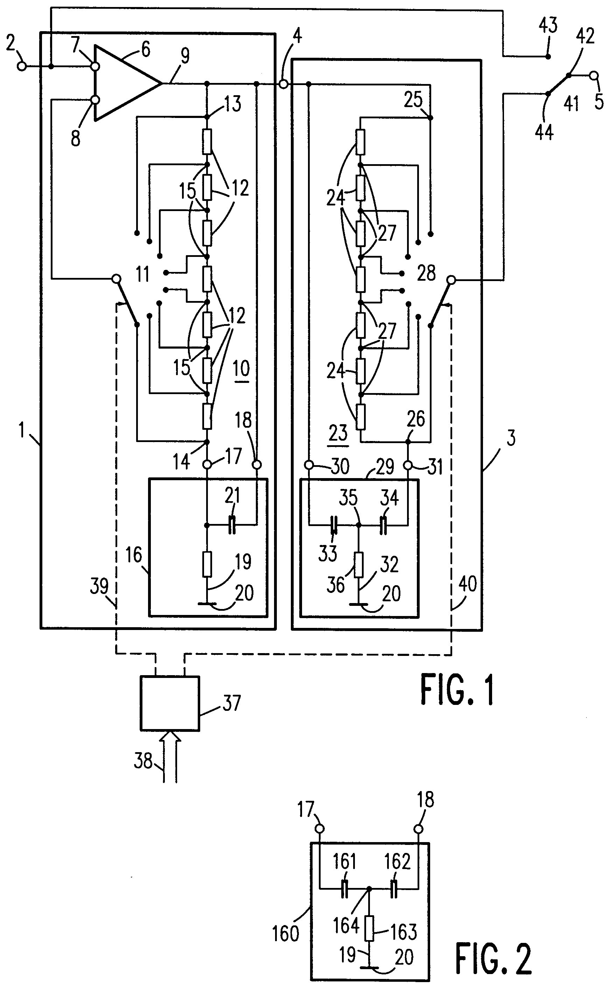

In Fig. 1 ist mit dem Bezugszeichen 1 eine Tiefenstellerstufe bezeichnet, die mit einem Signaleingang 2 verbunden ist, über die ein Signal zuführbar ist, welches einen vorgegebenen Übertragungs-Frequenzbereich aufweist und welches innerhalb dieses in seinem Amplituden-Frequenzgang gesteuert werden soll. Beispielhaft sei angenommen, daß es sich bei diesem Signal um ein Tonsignal handelt, dessen Übertragungs-Frequenzbereich sich zwischen 20 Hz und 20 kHz befindet. Die Schaltungsanordnung nach Fig. 1 wird dann bevorzugt zur gehörrichtigen Lautstärkesteuerung verwendet. Selbstverständlich sind jedoch auch Signale anderer Frequenzbereiche und anderer Anwendungen möglich.

Die Schaltungsanordnung nach Fig. 1 umfaßt weiterhin eine Kerbfilterstufe 3, die mit ihrem Eingangsanschluß an einen Ausgangsanschluß der Tiefenstellerstufe 1 angeschlossen ist. Diese beiden miteinander verbundenen Anschlüsse sind in Fig. 1 als Verbindungspunkt 4 dargestellt. Von der Kerbfilterstufe 3 wird das bearbeitete Signal einem Signalausgang 5 zugeleitet.

Die Tiefenstellerstufe 1 umfaßt einen Verstärker 6, der als Differenzverstärker mit einem nicht invertierenden Eingang 7 ausgestattet ist, der mit dem Signaleingang 2 verbunden ist, und der einen invertierenden Eingang 8 aufweist sowie einen Ausgang 9. Zwischen dem Ausgang 9 und dem invertierenden Eingang 8 ist eine steuerbare Gegenkopplung angeordnet, die eine erste Spannungsteileranordnung 10 mit frequenzabhängigem Verhalten sowie einen ersten elektronisch steuerbaren Umschalter 11 umfaßt. Die erste Spannungsteileranordnung 10 enthält eine erste Widerstandskette 12 aus einer Reihenschaltung ohmscher Widerstände. Diese erste Widerstandskette ist mit ihrem ersten Endpunkt 13 mit dem Verbindungspunkt 4 und damit mit dem Ausgang 9 des Verstärkers 6 verbunden. Ein zweiter Endpunkt 14 der ersten Widerstandskette 12 sowie Verbindungspunkte 15 der ohmschen Widerstände der ersten Widerstandskette 12 bilden eine Reihe von Abgriffen der ersten Spannungsteileranordnung, die wahlweise über den ersten Umschalter 11 mit dem invertierenden Eingang 8 des Verstärkers 6 verbindbar sind. Im Beispiel nach Fig. 1 umfaßt die erste Widerstandskette 12 sieben ohmsche Widerstände und somit zwei Endpunkte und sechs Verbindungspunkte, die insgesamt acht Abgriffe der ersten Spannungsteileranordnung ergeben. Entsprechend weist der erste Umschalter 11 acht Schalterstellungen auf.

In Fig. 1 ist der erste Umschalter 11 der Einfachheit halber als mechanischer Umschalter mit einem Kontaktarm und acht Umschaltkontakten dargestellt. In einer praktischen Ausführung wird ein solcher Umschalter jedoch durch elektronische Schaltmittel ersetzt. Dabei können selbstverständlich auch mehr oder weniger als die in Fig. 1 beispielhaft angenommenen acht Abgriffe eingerichtet werden, wobei die erste Widerstandskette 12 dann eine entsprechend erhöhte oder reduzierte Anzahl ohmscher Widerstände erhält. Eine derartige Spannungsteileranordnung ist dann sehr vorteilhaft auf einem Halbleiterkörper integrierbar und bevorzugt durch digitale Signale steuerbar. Grundsätzlich können jedoch der erste Umschalter 11 und die erste Widerstandskette 12 auch als analoge Potentiometerschaltung aufgebaut werden, wodurch sich die Art der Bearbeitung des dem Signaleingang 2 zuzuführenden Signals nicht ändert.

Die erste Spannungsteileranordnung 10 umfaßt weiterhin ein erstes Netzwerk 16 mit frequenzabhängigem Verhalten, welches mit einem ersten Anschluß 17 an den zweiten Endpunkt 14 der ersten Widerstandskette 12, mit einem zweiten Anschluß 18 an den Ausgang 9 des Verstärkers 6 und damit an den Verbindungspunkt 4 und mit einem dritten Anschluß 19 an Masse 20 angeschlossen ist. Dieses erste Netzwerk 16 umfaßt in der Ausgestaltung gemäß Fig. 1 zwischen dem ersten Anschluß 17 und dem zweiten Anschluß 18 einen ersten Kondensator 21, der die Endpunkte 13, 14 der ersten Widerstandskette 12 überbrückt, sowie einen ersten ohmschen Widerstand 22 zwischen dem ersten und dem dritten Anschluß 17 bzw. 19 des ersten Netzwerks 16, der den zweiten Endpunkt 14 der ersten Widerstandskette 12 mit Masse 20 verbindet. Durch das erste Netzwerk 16 erhält die erste Spannungsteileranordnung 10 ein frequenzabhängiges Verhalten der Art, daß das dem Signaleingang 2 zugeführte Signal dem Ausgang 9 des Verstärkers 6 und damit dem Verbindungspunkt 4 mit bei den tiefen Frequenzen angehobenem Amplituden-Frequenzgang entnehmbar ist.

Die Kerbfilterstufe 3 der Schaltungsanordnung nach Fig. 1 enthält eine zweite Spannungsteileranordnung 23 mit frequenzabhängigem Verhalten, die eine zweite Widerstandskette 24 aus einer Reihenschaltung ohmscher Widerstände umfaßt. Die zweite Widerstandskette ist mit einem ersten Endpunkt 25 an den Verbindungspunkt 4 und damit an den Endanschluß der zweiten Spannungsteileranordnung 23 angeschlossen, dem das Signal von der Tiefenstellerstufe 1 zuführbar ist. Ein zweiter Endpunkt 26 der zweiten Widerstandskette 24 sowie Verbindungspunkte 27 zwischen den einzelnen ohmschen Widerständen der zweiten Widerstandskette 24 bilden zusammen mit dem ersten Endpunkt 25 Abgriffe der zweiten Spannungsteileranordnung 23; diese Abgriffe sind mit Umschaltkontakten eines zweiten elektronisch steuerbaren Umschalters 28 verbunden, dessen Kontaktarm mit dem Signalausgang 5 gekoppelt ist. Für die Ausbildung der zweiten Widerstandskette 24 und des zweiten elektronisch steuerbaren Umschalters 28 bzw. seine Darstellung in Fig. 1 gelten die Ausführungen zum ersten Umschalter 11 und zur ersten Widerstandskette 12 entsprechend.

Die zweite Spannungsteileranordnung 23 umfaßt weiterhin ein zweites Netzwerk 29 mit frequenzabhängigem Verhalten, das mit einem ersten Anschluß 30 an den ersten Endpunkt 25 der zweiten Widerstandskette 24, mit einem zweiten Anschluß 31 an den zweiten Endpunkt 26 der zweiten Widerstandskette 24 und mit einem dritten Anschluß 32 an Masse 20 angeschlossen ist. Somit ist der erste Anschluß 30 auch mit dem Verbindungspunkt 4 verbunden. Das zweite Netzwerk 29 enthält zwischen seinem ersten Anschluß 30 und seinem zweiten Anschluß 31 eine Reihenschaltung aus einem vierten Kondensator 33 und einem fünften Kondensator 34, die somit die zweite Widerstandskette 24 überbrückt bzw. durch diese überbrückt wird. Ein Verbindungspunkt 35 zwischen dem vierten Kondensator 33 und dem fünften Kondensator 34 ist über einen ebenfalls von dem zweiten Netzwerk 29 umfaßten dritten ohmschen Widerstand 36 mit dem an Masse angeschlossenen dritten Anschluß 32 des zweiten Netzwerks 29 verbunden.

Das zweite Netzwerk 29 bestimmt das frequenzabhängige Verhalten der zweiten Spannungsteileranordnung 23 und damit der Kerbfilterstufe 3. Es stellt ein durch die zweite Widerstandskette 24 überbrücktes T-Filter dar. Durch die Kerbfilterstufe wird der Amplituden-Frequenzgang des am Verbindungspunkt 4 zugeführten Signals bei mittleren Frequenzen des Übertragungs-Frequenzbereichs abgesenkt. Die Lage des Frequenzbereichs, in welchem dieses Absenken auftritt, wird durch die Dimensionierung der Elemente des zweiten Netzwerks 29 und auch der zweiten Widerstandskette 24 vorgegeben. Das Maß der Absenkung, d.h. der Grad der Signalschwächung, ist über den zweiten Umschalter 28 unabhängig von der Tiefenstellerstufe 1 einstellbar.

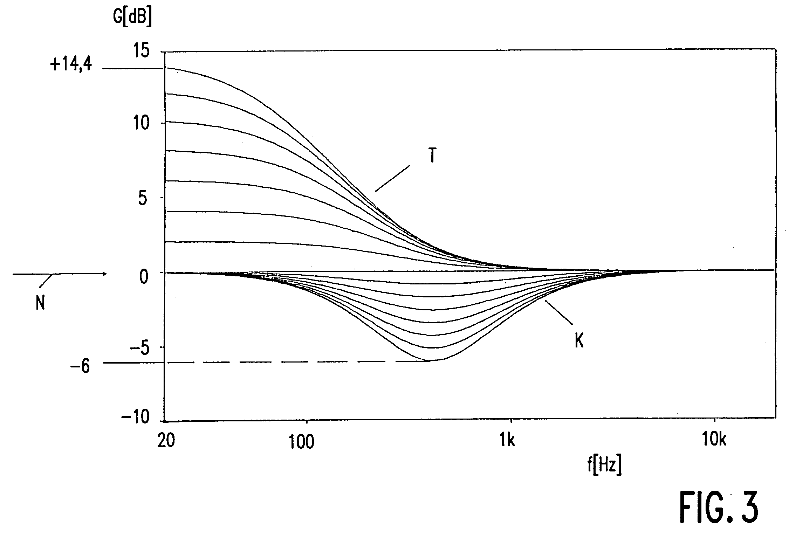

Fig. 3 zeigt für ein Dimensionierungsbeispiel der Fig. 1 die Amplituden-Frequenzgänge der Tiefenstellerstufe 1 für die einzelnen Schaltstellungen des ersten Umschalters 11 und die Amplituden-Frequenzgänge der Kerbfilterstufe 3 für die einzelnen Schalterstellungen des zweiten Umschalters 28. Dabei ist in der Horizontalen die Frequenz f des Signals und in der Vertikalen die Verstärkung G für das zu bearbeitende Signal zwischen dem Signaleingang 2 und dem Verbindungspunkt 4 für die Tiefenstellerstufe 1 bzw. zwischen dem Verbindungspunkt 4 und dem Signalausgang 5 für die Kerbfilterstufe 3 aufgetragen. Oberhalb der mit 0 Dezibel bezeichneten waagerechten Linie für eine Verstärkung von 1 ist die Kurvenschar T für den Amplituden-Frequenzgang der Tiefenstellerstufe 1 bei den einzelnen Schalterstellungen des ersten Umschalters 11 aufgetragen, wobei die waagerechte Linie bei 0 Dezibel der Schalterstellung entspricht, in der der erste Endpunkt 13 der ersten Widerstandskette 12 mit dem invertierenden Eingang des Verstärkers 6 verbunden ist. Mit fortlaufendem Umschalten auf die einzelnen Verbindungspunkte 15 werden nacheinander die Kurven der Kurvenschar T oberhalb der Linie "0 Dezibel" eingenommen, und die oberste Linie der Kurvenschar T entspricht dem Amplituden-Frequenzgang der Tiefenstellerstufe 1, wenn durch den ersten Umschalter 11 der zweite Endpunkt 14 der ersten Widerstandskette 12 mit dem invertierenden Eingang 8 des Verstärkers 6 verbunden ist. Im vorliegenden Dimensionierungsbeispiel wird dabei an der unteren Grenze des Übertragungs-Frequenzbereichs - hier 20 Hz - eine Verstärkung von 14,4 Dezibel erhalten. Bei mittleren Frequenzen nähern sich die Kurven der Kurvenschar einander an und gehen für hohe Frequenzen des Übertragungs-Frequenzbereichs ineinander und in die Linie "0 Dezibel" über.

In Fig. 3 ist mit K eine Kurvenschar bezeichnet, die den Amplituden-Frequenzgang nur des Kerbfilters 3 für die unterschiedlichen Schalterstellungen des zweiten Umschalters 28 zeigt. Dabei entspricht die waagerechte Linie bei einer Verstärkung G von 0 Dezibel derjenigen Stellung des Kontaktarms des zweiten Umschalters 28, in der der erste Endpunkt 25 der zweiten Widerstandskette 24 unmittelbar, d.h. ohne Zwischenschalten eines der ohmschen Widerstände der zweiten Widerstandskette 24, mit dem Signalausgang 5 gekoppelt ist. Die nach unten, d.h. zu größeren Absenkungen der Verstärkung G hin eingezeichneten Kurven geben den Amlituden-Frequenzgang für die einzelnen Schalterstellungen des Kontaktarms des zweiten Umschalters 28 wieder; die Kurve der Kurvenschar K mit der größten Absenkung der Verstärkung G - im Dimensionierungsbeispiel nach Fig. 3 entspricht diese Absenkung 6 Dezibel - zeigt den Amplituden-Frequenzgang der Kerbfilterstufe 3 in der Schalterstellung des zweiten Umschalters 28, in der der zweite Endpunkt 26 der zweiten Widerstandskette 24 mit dem Signalausgang 5 gekoppelt ist. Durch den zweiten Umschalter 28 kann somit das Maß der Absenkung der Verstärkung G im Bereich mittlerer Frequenzen - beim Dimensionierungsbeispiel nach Fig. 3 etwa im Bereich zwischen 200 Hz und 1 kHz - gewählt werden.

Die waagerechte Linie bei einer Verstärkung G von 0 Dezibel, die sowohl den Amplituden-Frequenzgang der Tiefenstellerstufe 1 in der Stellung des ersten Umschalters 11 wiedergibt, in der der erste Endpunkt 13 der ersten Widerstandskette 12 mit dem invertierenden Eingang 8 des Verstärkers 6 verbunden ist, und die weiterhin den Amplituden-Frequenzgang der Kerbfilterstufe 3 wiedergibt in der Schalterstellung des zweiten Umschalters 28, in der der erste Endpunkt 25 der zweiten Widerstandskette 24 direkt mit dem Signalausgang 5 gekoppel ist, beschreibt somit den Amplituden-Frequenzgang der gesamten Schaltungsanordnung nach Fig. 1 zwischen dem Signaleingang 2 und dem Signalausgang 5, wenn sowohl die Tiefenstellerstufe 1 als auch die Kerbfilterstufe 3 wirkungslos geschaltet sind.

Die einzelnen Kurven der Kurvenscharen T und K für die unterschiedlichen Einstellungen der Tiefenstellerstufe und der Kerbfilterstufe können entsprechend den unterschiedlich wählbaren Kombinationen der Schalterstellungen der Umschalter 11 bzw. 28 in vielfältiger Weise überlagert werden. Dabei können beispielsweise Kurven mit geringer Anhebung des Amplituden-Frequenzgangs bei niedrigen Frequenzen mit Kurven geringer Absenkung des Amplituden-Frequenzgangs bei mittleren Frequenzen und entsprechend Kurven hoher Anhebung mit Kurven großer Absenkung überlagert werden. Die Umschalter 11 bzw. 28 werden dann gleichsinnig verstellt. Die Erfindung bietet jedoch auch die Möglichkeit, die Anhebung des Amplituden-Frequenzgangs bei niedrigen Frequenzen unabhängig von der Absenkung bei mittleren Frequenzen den jeweiligen Anforderungen an die Eigenschaften der Quellen, aus denen das zu bearbeitende Signal zuführbar ist, und der Senken, an die es weiterleitbar ist, anzupassen. Handelt es sich dabei beispielsweise um Tonsignale, können Lautsprecher oder vergleichbare Tonwiedergabesysteme in Gebäuden andere Übertragungseigenschaften und damit andere Anforderungen an die Formung des Amplituden-Frequenzgangs aufweisen als vergleichbare Vorrichtungen in Kraftfahrzeugen. Tonsignale von Aufzeichnungsgeräten können wiederum andere Anforderungen stellen als solche von Rundfunkempfangsanlagen oder dergleichen. Für jeden Fall und damit auch für jede beliebige Kombination von Quelle und Senke kann in einfacher Weise ein optimaler Verlauf des Amplituden-Frequenzgangs gewählt werden.

Bei einer derartigen Anwendung der erfindungsgemäßen Schaltungsanordnung wird diese bevorzugt in Kombination mit einer Einrichtung zur Einstellung der Verstärkung G eingesetzt, die im einfachsten Fall eine Anhebung oder Absenkung der Verstärkung des Signals unabhängig von der Frequenz, d.h. im gesamten Übertragungs-Frequenzbereich gleichmäßig, vornimmt. Eine derartige Einrichtung kann mit ihrem Ausgang beispielsweise an den Signaleingang 2 der Schaltungsanordnung nach Fig. 1 angeschlossen sein und ist in Fig. 1 nicht näher dargestellt. Wird sie zusammen mit der Schaltungsanordnung nach Fig. 1 verwendet, entspricht die in Fig. 3 mit N gekennzeichnete Linie der Verstärkung G von 0 Dezibel der Verstärkung bzw. dem Signalpegel, der am Signaleingang 2 vorliegt. Dieser Verstärkung bzw. diesem Signalpegel mit im idealen Fall, aber nicht notwendigerweise frquenzunabhängigem Amplituden-Frequenzgang im gesamten Übertragungs-Frequenzbereich wird dann der Amplituden-Frequenzgang der Schaltungsanordnung nach Fig. 1 überlagert. Sollten im Amplituden-Frequenzgang am Signaleingang 2 unerwünschte Unregelmäßigkeiten auftreten, können diese auch in bestimmtem Maße durch die erfindungsgemäße Schaltungsanordnung ausgeglichen werden.

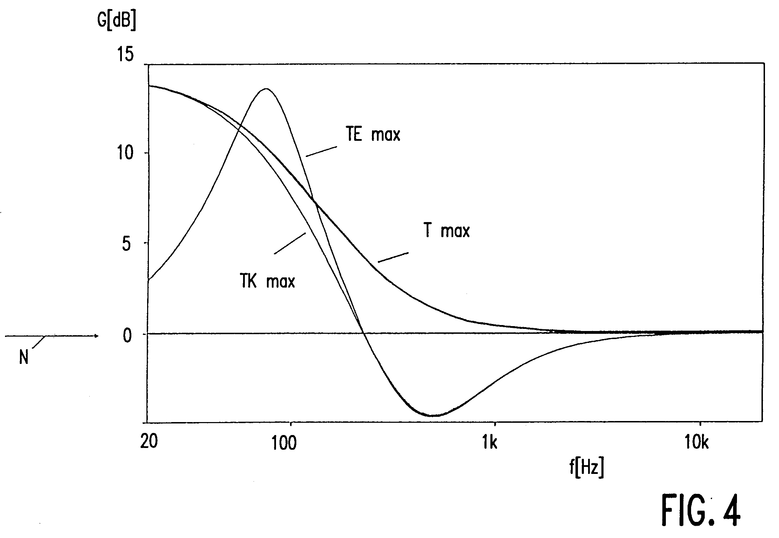

Im Diagramm nach Fig. 4 sind zum Vergleich der unterschiedlichen, einstellbaren Amplituden-Frequenzgänge außer der schon aus Fig. 3 bekannten Linie N eine Kurve Tmax und eine weitere Kurve TKmax aufgetragen. Die Kurve Tmax entspricht dem Amplituden-Frequenzgang der Tiefenstellerstufe bei maximaler Anhebung bei niedrigen Frequenzen entsprechend der obersten der Kurven aus der Kurvenschar T bei gleichzeitig wirkungslos geschalteter Kerbfilterstufe 3. Die Kurve TKmax stellt eine Überlagerung der Kurve Tmax mit derjenigen Kurve aus der Kurvenschar K dar, die die maximale Absenkung durch die Kerbfilterstufe 3 bei mittleren Frequenzen wiedergibt. Sehr gut erkennbar ist anhand dieser Kurven Tmax und TKmax in Fig. 4 der steilere Verlauf im Übergang zwischen den niedrigen und den mittleren Frequenzen, der sich durch die Kerbfilterstufe 3 ergibt. Gerade dieser steile Übergang beispielsweise ist für die Tonsignalbearbeitung in Autoradios bedeutungsvoll.

Die beschriebene Steuerung der Umschalter 11 und 28 erfolgt bei der Schaltungsanordnung nach Fig. 1 durch eine Steuerschaltung 37, der bevorzugt über eine Datenleitung 38 Steuerdaten zuführbar sind und die daraus Steuersignale formt, durch die über Steuerleitungen 39 bzw. 40 die Umschalter 11 bzw. 28 betätigbar sind. Die Steuerschaltung 37 und die Datenleitung 38 können bei Einsatz der erfindungsgemäßen Schaltungsanordnung mit anderen Signalverarbeitungsstufen auch mit deren Steuereinrichtungen kombinierbar sein.

Die Schaltungsanordnung nach Fig. 1 weist weiterhin einen dritten Umschalter 41 auf, dessen Ausgang 42 mit dem Signalausgang 5 verbunden ist und der zwei Eingänge 43, 44 aufweist, von denen ein erster Eingang 43 mit dem Signaleingang 2 und ein zweiten Eingang 44 mit dem Kontaktarm des zweiten Umschalters 28 verbunden ist. Dadurch ist dem Signalausgang 5 über den dritten Umschalter 41 wahlweise das Signal vom Signaleingang 2 unmittelbar oder das durch die Tiefenstellerstufe 1 und die Kerbfilterstufe 3 bearbeitete Signal zuleitbar. Wahlweise kann der dritte Umschalter 41 auch durch die Steuerschaltung 37 steuerbar ausgeführt sein, was in Fig. 1 aus Gründen der Übersichtlichkeit nicht dargestellt ist. Durch den dritten Umschalter 41 wird zum Wirkungslosschalten der Tiefenstellerstufe 1 und der Kerbfilterstufe 3 sowohl der Verstärker 6 als auch der zweite Umschalter 28 überbrückt, wodurch insbesondere das Rauschverhalten der Schaltungsanordnung bei eingestelltem linearen Frequenzgang verbessert werden kann.

In einer Abwandlung der Schaltungsanordnung nach Fig. 1, die in Fig. 2 dargestellt ist, weist bei ansonsten unveränderter Schaltungsanordnung das erste Netzwerk - jetzt mit dem Bezugszeichen 160 versehen - zwischen seinem ersten und zweiten Anschluß 17 bzw. 18 eine Reihenschaltung aus einem zweiten Kondensator 161 und einem dritten Kondensator 162 auf, die über die Anschlüsse 17 bzw. 18 die Endpunkte 13 bzw. 14 der ersten Widerstandskette 12 überbrückt. Das erste Netzwerk 160 gemäß Fig. 2 umfaßt weiterhin einen zweiten ohmschen Widerstand 163, der einen Verbindungspunkt 164 zwischen dem zweiten Kondensator 161 und dem dritten Kondensator 162 mit dem an Masse 20 angeschlossenen dritten Anschluß 19 des ersten Netzwerks 160 gemäß Fig. 2 verbindet. Das erste Netzwerk 160 gemäß Fig. 2 entspricht somit in seinem Aufbau dem zweiten Netzwerk 29 der Kerbfilterstufe 3; es stellt ein durch die erste Widerstandskette 12 überbrücktes T-Filter dar. Dadurch erhält die derart modifizierte Tiefenstellerstufe 1 einen Amplituden-Frequenzgang, der von mittleren Frequenzen des Übertragungs-Frequenzberei her kommend bei Verringern der Frequenz zunächst eine Anhebung aufweist, jedoch am niederfrequenten Rand des Übertragungs-Frequenzbereichs wiederum eine Absenkung verzeichnet. Ein Beispiel für einen derartigen Verlauf des Amplituden-Frequenzgangs zeigt die Kurve TEmax in Fig. 4, in der der Amplituden-Frequenzgang einer Schaltungsanordnung nach Fig. 1 in Abwandlung gemäß Fig. 2 mit maximaler Anhebung des Amplituden-Frequenzgangs bei niedrigen Frequenzen und maximaler Absenkung durch die Kerbfilterstufe 3 bei mittleren Frequenzen dargestellt ist. Entsprechend der Kurvenschar T in Fig. 3 ergibt sich durch Verändern der Einstellung des ersten Umschalters 11 auch für die so abgewandelte Tiefenstellerstufe 1 eine Kurvenschar mit verminderter Anhebung des Amplituden-Frequenzgangs unterhalb der Kurve TEmax, und auch die einzelnen Kurven dieser Kurvenschar können beliebig mit einzelnen Kurven der Kurvenschar K der Kerbfilterstufe 3 kombiniert werden.

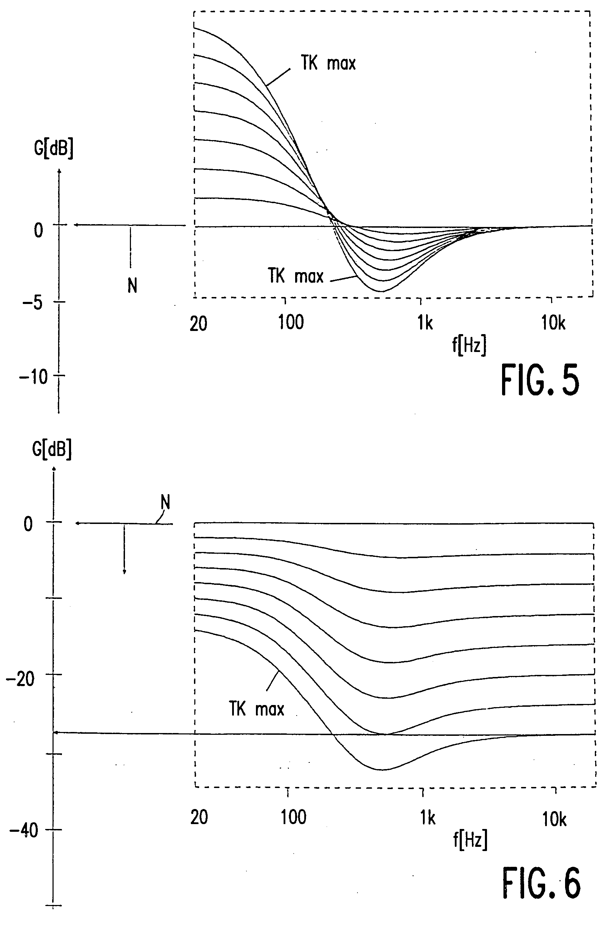

Die Schaltungsanordnung nach Fig. 1 mit der Abwandlung gemäß Fig. 2 ist besonders vorteilhaft einsetzbar für die gehörrichtige Lautstärkesteuerung bei Autoradios, um Übersteuern und Dröhnen sehr niederfrequenter Tonsignale bzw. Schallschwingungen zu unterdrücken. Ein anderer Anwendungsfall ist die Wiedergabe von Tonsignalen aus digitalen Aufzeichnungsträgern, insbesondere optischen Aufzeichnungsplatten ("Compact Disc"), die auch bei Frequenzen am niederfrequenten Rand des Übertragungs-Frequenzbereichs, beispielsweise unterhalb von 40 Hz, noch Tonsignale enthalten. Diese gelangen bei einer gemäß Fig. 1 und der Kurvenschar T gemäß Fig. 3 ausgebildeten Tiefenstellerstufe 1 in der erfindungsgemäßen Schaltungsanordnung am Signalausgang 5 nachgeschaltete Signalbearbeitungsstufen und Wiedergabevorrichtungen, beispielsweise Baßendstufen und zugehörige Lautsprecher, und führen bei einer entsprechenden Anhebung des Amplituden-Frequenzgangs zu einer hohen Aussteuerung und damit zu hohen Verlustleistungen in den genannten Einrichtungen. Diese Verlustleistung bewirkt eine nutzlose Wärmeentwicklung, im Extremfall eine Zerstörung der genannten Stufen. Mit einem Amplituden-Frequenzgang gemäß der Kurve TEmax gemäß Fig. 4, d.h. einem steilen Baßabfall im Bereich des niederfrequenten Randes des Übertragungs-Frequenzbereichs, kann dieser Gefahr wirksam begegnet werden. Außerdem ermöglicht die Abwandlung der Schaltungsanordnung nach Fig. 1 gemäß der Fig. 2 eine Verlagerung der maximalen Baßanhebung in einen Frequenzbereich, bei dem insbesondere auch ein preiswerter Lautsprecher die ihm zugeführte elektrische Energie der Tonsignale noch in eine Schallschwingung umwandeln kann. Dadurch wird einerseits eine Verringerung der Kosten für die gesamte Tonsignal-Wiedergabeeinrichtung bei andererseits verbessertem Wirkungsgrad erreicht. Die Fig. 5 bis 7 zeigen abschließend drei Beispiele für eine von der Einstellung der Gesamtverstärkung einer Tonwiedergabeeinrichtung abhängige Steuerung der Tiefenstellerstufe 1 und der Kerbfilterstufe 3 in der Ausbildung gemäß Fig. 1 für eine gehörrichtige Laustärkesteuerung. In den verschiedenen Diagrammen ist dabei der Einfachheit halber stets eine Steuerung der Umschalter 11 und 28 angenommen, bei der deren Kontaktarme gleichsinnig verstellt werden, so daß bei niedriger Anhebung des Amplituden-Frequenzgangs bei niedrigen Frequenzen auch eine geringe Absenkung des Amplituden-Frequenzgangs bei mittleren Frequenzen zur Anwendung kommt, wohingegen eine große Anhebung des Amplituden-Frequenzgangs bei niedrigen Frequenzen mit einer großen Absenkung bei mittleren Frequenzen verbunden ist. Dies entspricht im wesentlichen dem Standardfall der gehörrichtigen Lautstärkesteuerung, wobei die geringen Anhebungen bzw. Absenkungen einer insgesamt hohen Verstärkung G der Tonsignale zugeordnet werden, während die starke Anhebung der tiefen Frequenzen und die starke Absenkung der mittleren Frequenzen im Amplituden-Frequenzgang bei geringer Verstärkung G bzw. starker Abschwächung der Tonsignale zum Tragen kommt, um auch bei leiser Tonwiedergabe noch die Signale niedriger Frequenzen hörbar zu machen und den dominierenden Einfluß bei mittleren Frequenzen zu verringern. Dabei ist zu bedachten, daß - wie aus den Fig. 3 und 4 ersichtlich ist, die Verstärkung G durch die Tiefenstellerstufe 1 und die Kerbfilterstufe 3 bei hohen Frequenzen des Übertragungs-Frequenzbereichs grundsätzlich nicht verändert wird.

Fig. 5 zeigt dementsprechend eine Schar von Kurven, die durch die beschriebene, gleichsinnige Verstellung der Umschalter 11 bzw. 28 der Tiefenstellerstufe 1 bzw. der Kerbfilterstufe 3 bei einem am Signaleingang 2 mit unverändertem Pegel, d.h. mit unveränderter Verstärkung G und mit einem für alle Frequenzen des Übertragungs-Frequenzbereichs konstanten Pegel zugeführten Signal erhalten wird. Entsprechend der Anzahl der Umschaltkontakte bzw. Abgriffe der Umschalter 11 bzw. 28 bzw. der ersten bzw. zweiten Widerstandskette 12 bzw. 24 umfaßt auch die in Fig. 5 gezeigte Kurvenschar acht Kurven, wobei eine waagerechte Kurve umfaßt ist, die einen konstanten Amplituden-Frequenzgang entsprend einem Unwirksamschalten sowohl der Tiefenstellerstufe 1 als auch der Kerbfilterstufe 3 aufweist. Für hohe Frequenzen im Übertragungs-Frequenzbereich ist die Verstärkung G bei allen Kurven der Kurvenschar 5 identisch. Somit zeigt die Fig. 5 verschiedene Stufen einer gehörrichtigen Lautstärkesteuerung ohne Änderung einer extern vorzunehmenden Lautstärkeeinstellung.

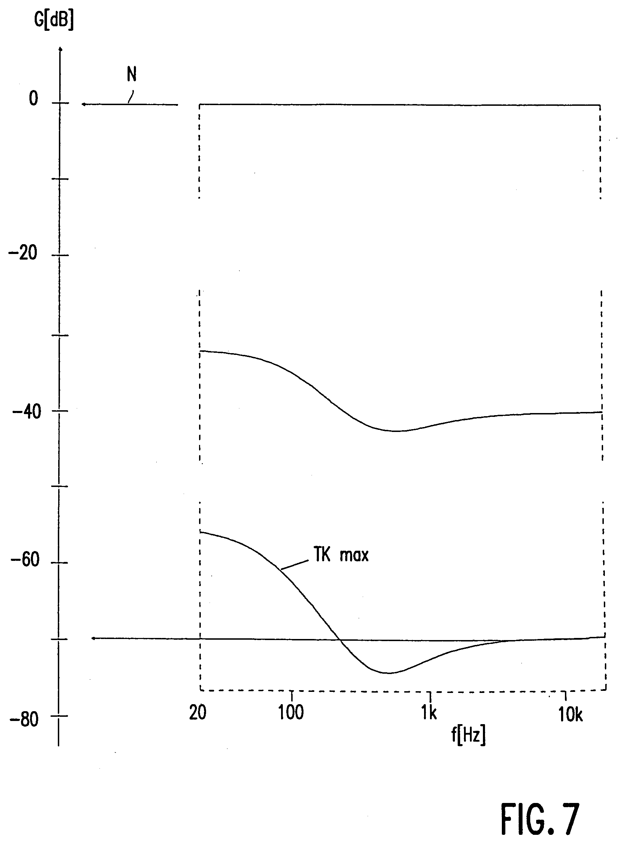

Fig. 6 zeigt eine Kurvenschar, deren einzelne Kurven in der gleichen Weise erzeugt wurden wie diejenigen der Kurvenschar gemäß Fig. 5. Zusätzlich ist jedoch jeder Kurve eine mit zunehmender Anhebung bzw. Absenkung des Amplituden-Frequenzgangs bei tiefen bzw. mittleren Frequenzen zunehmende Dämpfung des Signals, d.h. eine abnehmende Lautstärke und damit abnehmende Gesamtverstärkung G überlagert. Dieser Fall entspricht dem Prinzip der bekannten gehörrichtigen Lautstärkesteuerung, bei der mit abnehmender Lautstärke die Anhebung bzw. Absenkung in den beschriebenen Frequenzbereichen zunimmt. Fig. 7 zeigt eine Abwandlung der Kurvenschar nach Fig. 6, bei der gegenüber dem in Fig. 6 dargestellten Fall eine wesentlich größere Signaldämpfung, d.h. eine wesentlich stärkere Verringerung der Verstärkung G durch einen mit der Schaltungsanordnung nach Fig. 1 verkoppelten Lautstärkesteller vorgenommen ist. Der Übersichtlichkeit halber sind in Fig. 7 nur die Linie N für eine Verstärkung G von 0 Dezibel und die Kurve TKmax für maximale Anhebung bei tiefen Frequenzen und maximale Absenkung bei mittleren Frequenzen eingezeichnet, die auch aus den Diagrammen der Fig. 4, 5 und 6 zu entnehmen sind, sowie eine Kurve für einen Zwischenwert der Einstellungen eingezeichnet.

Die senkrechte Skala für die Verstärkung G in den Fig. 5 bis 7 ist derart bemaßt, daß bei Unwirksamschalten der Tiefenstellerstufe 1 und der Kerbfilterstufe 3 und bei maximaler Verstärkung durch eine damit verbundene Lautstärkeeinstelleinrichtung stets ein Wert von 0 Dezibel vorliegt. Selbstverständlich sind Abweichungen in den in den Fig. 5 bis 7 gezeigten Charakteristiken möglich. Diese Variationen betreffen zum einen veränderte Kombinationen der Einstellungen der Umschalter 11 bzw. 28, womit die Form der Kurvenscharen variiert werden kann, und zum anderen veränderte Zuordnungen zwischen den externen Lautstärkeeinstellungen und den Einstellungen des Amplituden-Frequenzgangs durch die Tiefenstellerstufe 1 bzw. die Kerbfilterstufe 3. Anstelle der Tiefenstellerstufe 1 gemäß Fig. 1 kann selbstverständlich auch die Abwandlung gemäß Fig. 2 zum Einsatz kommen. Um beispielsweise eine Übersteuerung nachgeschalteter Signalverarbeitungseinrichtungen bei einer Auslegung gemäß Fig. 5 zu vermeiden, kann dieser Einsatzfall beispielsweise dahingehend verändert werden, daß nur die Kurven mit den größeren Anhebungen des Amplituden-Frequenzgangs bei niedrigen Frequenzen durch eine damit verbundene Absenkung der Verstärkung insgesamt durch die externe Lautstärkeeinstelleinrichtung insgesamt abgesenkt werden, um eine höchstzulässige Verstärkung G nicht zu überschreiten.

Die erfindungsgemäße Schaltungsanordnung kann bevorzugt auf einem Halbleiterkörper integriert werden. Dabei ist es vorteilhaft, wenn der erste Anschluß 17 des ersten Netzwerks 16, eine Verbindung aus dem Verbindungspunkt 4, dem zweiten Anschluß 18 des ersten Netzwerks 16 und dem ersten Anschluß 30 des zweiten Netzwerks 29 und zum dritten der zweite Anschluß 31 des zweiten Netzwerks 29 als externe Anschlüsse dieser integrierten Schaltungsanordnung ausgeführt werden. Die Netzwerke 16 und 29 bzw. 160 werden dann als externe Bauelemente ausgeführt. Damit können auch die Amplituden-Frequenzgänge durch unterschiedliche Dimensionierung der Netzwerke 16, 29 bzw. 160 sehr einfach den jeweiligen Anforderungen angepaßt werden.

Die Schaltungsanordnung gemäß der Erfindung kann auch in einfacher Weise für abgewandelte Einsatzzwecke eingerichtet werden. Beispielsweise kann der zweite Umschalter 28 in eine Schalterstellung überführt werden, in der der erste Endpunkt 25 der zweiten Widerstandskette 24 unmittelbar mit dem Signalausgang 5 verbunden ist. Die Kerbfilterstufe 3 ist dann unwirksam. Gegebenenfalls kann das allein von der Tiefenstellerstufe 1 bearbeitete Signal auch am Verbindungspunkt 4 unmittelbar abgegriffen werden, wenn dieser wie vorstehend beschrieben als externer Anschluß ausgeführt ist. Die Schaltungsanordnung wird dann lediglich als Baßsteller verwendet.

In einer anderen Dimensionierung kann die Kerbfilterstufe 3 auch so ausgelegt sein, daß durch sie ähnlich wie beim ersten Netzwerk 160 der Fig. 2 beschrieben nicht nur eine gehörrichtige Verstärkungsanpassung, sondern auch eine Unterdrückung von parasitären Resonanzen beispielsweise im Fahrzeuginnenraum beim Einsatz in einem Autoradio erzielt wird.

Die erfindungsgemäße Schaltungsanordnung bietet insbesondere bei einem Einsatz zur gehörrichtigen Lautstärkesteuerung den Vorteil, daß eine Trennung zwischen der für alle Frequenzen des Übertragungs-Frequenzbereichs gleichmäßigen Lautstärkeeinstellung einerseits und der gehörrichtigen Anhebung bzw. Absenkung in einzelnen Abschnitten des Übertragungs-Frequenzbereichs vorliegt. Dadurch ist eine beliebige Kombination beider Funktionen mit einfachen Mitteln möglich. Auf diese Weise können insbesondere unterschiedliche Quellen für die Signale mit unterschiedlichen Signalpegeln, aber auch unterschiedlichen Amplituden-Frequenzgängen, durch eine entsprechende Einstellung in der Steuerschaltung 37 in Kombination mit der Lautstärkeeinstellung berücksichtigt werden. Unabhängig vom Pegel der jeweiligen Quelle und auch unabhängig von den Eigenschaften der verfügbaren Senken für die Signale kann die jeweils erforderliche Lautstärkesteuerung vorgenommen werden. Dies kann auch automatisch durch das Zuschalten der jeweiligen Quelle erfolgen. Damit läßt sich bei der Umschaltung auf unterschiedliche Quellen stets der gleiche Lautstärkeeindruck im gesamten Übertragungs-Frequenzbereich erzielen, wodurch die Tonsignale sämtlicher Quellen stets das gleiche Klangbild aufweisen. Dabei kann der Einstellbereich für die Lautstärke je nach auszurüstendem Gerätetyp ohne Einschränkungen frei gewählt werden. Vorteilhaft für die Dimensionierung ist ferner, daß durch die erfindungsgemäße gehörrichtige Lautstärkesteuerung keine Veränderung der insgesamt betrachteten Lautstärke, d.h. der Gesamtverstärkung des Signals, eintritt.

## Patentansprüche

1. Schaltungsanordnung mit steuerbarem Übertragungsverhalten zwischen einem Signaleingang (2) und einem Signalausgang (5) für ein Signal innerhalb eines vorgebbaren Übertragungs-Frequenzbereichs, mit einer Tiefenstellerstufe (1), der das Signal vom Signaleingang (2) zum einstellbaren Anheben des Amplituden-Frequenzgangs des Signals bei tiefen Frequenzen des Übertragungs-Frequenzbereichs zuführbar ist,
gekennzeichnet durch eine Kerbfilterstufe (3), der das in der Tiefenstellerstufe (1) bearbeitete Signal zuleitbar ist zum von der Tiefenstellerstufe (1) unabhängig einstellbaren Absenken des Amplituden-Frequenzgangs des Signals bei mittleren Frequenzen des Übertragungs-Frequenzbereichs und durch die das von ihr bearbeitete Signal dem Signalausgang zuführbar ist.

2. Schaltungsanordnung nach Anspruch 1,
dadurch gekennzeichnet, daß die Tiefenstellerstufe (1) mit einem Verstärker (6) mit steuerbarer Gegenkopplung ausgebildet ist, an dessen Ausgang (9) eine erste Spannungsteileranordnung (10) mit frequenzabhängigem Verhalten angeschlossen ist, die mit mehreren Abgriffen versehen ist, die über einen ersten elektronisch steuerbaren Umschalter (11) mit einem invertierenden Eingang (8) des Verstärkers (6) verbindbar sind, wobei ein nicht invertierender Eingang (7) des Verstärkers (6) mit dem Signaleingang (2) der Schaltungsanordnung verbunden ist und dem Ausgang (9) des Verstärkers (6) das Signal mit bei den tiefen Frequenzen angehobenem Amplituden-Frequenzgang entnehmbar ist.

3. Schaltungsanordnung nach Anspruch 2,
dadurch gekennzeichnet, daß die erste Spannungsteileranordnung (10) umfaßt:
- eine durch eine Reihenschaltung ohmscher Widerstände gebildete erste Widerstandskette (12), deren Verbindungs- (15) und Endpunkte (13, 14) die Abgriffe bilden, wobei ein erster 13) der Endpunkte der ersten Widerstandskette (12) mit dem Ausgang (9) des Verstärkers (6) verbunden ist, und
- ein erstes Netzwerk (16) mit frequenzabhängigem Verhalten, das mit einem ersten Anschluß (17) an einen zweiten (14) der Endpunkte der ersten Widerstandskette (12), mit einem zweiten Anschluß (18) an den Ausgang (9) des Verstärkers (6) und mit einem dritten Anschluß (19) an Masse (20) angeschlossen ist.

4. Schaltungsanordnung nach Anspruch 3,
dadurch gekennzeichnet, daß das erste Netzwerk (16) zwischen seinem ersten (17) und zweiten Anschluß (18) einen ersten Kondensator (21) enthält und zwischen seinem ersten (17) und dritten Anschluß (19) einen ersten ohmschen Widerstand (22) aufweist.

5. Schaltungsanordnung nach Anspruch 3,
dadurch gekennzeichnet, daß das erste Netzwerk (160) zwischen einem ersten (17) und zweiten Anschluß (18) eine Reihenschaltung aus einem zweiten (161) und einem dritten Kondensator (162) enthält und einen zweiten ohmschen Widerstand (163) umfaßt, der einen Verbindungspunkt (164) zwischen dem zweiten (161) und dritten Kondensator (162) mit dem dritten Anschluß (19) des ersten Netzwerks (160) verbindet.

6. Schaltungsanordnung nach einem der vorhergehenden Ansprüche,
dadurch gekennzeichnet, daß die Kerbfilterstufe (3) eine zweite Spannungsteileranordnung (23) mit frequenzabhängigem Verhalten umfaßt, die mit mehreren Abgriffen versehen ist, die über einen zweiten elektronisch steuerbaren Umschalter (28) mit dem Signalausgang (5) der Schaltungsanordnung verbindbar sind, wobei einem Endanschluß (25) der zweiten Spannungsteileranordnung (23) das Signal von der Tiefenstellerstufe (1) zuführbar ist.

7. Schaltungsanordnung nach Anspruch 6,
dadurch gekennzeichnet, daß die zweite Spannungsteileranordnung (23) umfaßt:
- eine durch eine Reihenschaltung ohmscher Widerstände gebildete zweite Widerstandskette (24), deren Verbindungs- (27) und Endpunkte (25, 26) die Abgriffe bilden, wobei ein erster (25) der Endpunkte der zweiten Widerstandskette (24) mit dem Endanschluß (25) der zweiten Spannungsteileranordnung (23), dem das Signal von der Tiefenstellerstufe (1) zuführbar ist, verbunden ist, und
- ein zweites Netzwerk (29) mit frequenzabhängigem Verhalten, das mit einem ersten Anschluß (30) an den ersten Endpunkt (25) der zweiten Widerstandskette (24), mit einem zweiten Anschluß (31) an einen zweiten (26) der Endpunkte der zweiten Widerstandskette (24) und mit einem dritten Anschluß (32) an Masse (20) angeschlossen ist.

8. Schaltungsanordnung nach Anspruch 7,
dadurch gekennzeichnet, daß das zweite Netzwerk (29) zwischen seinem ersten (30) und zweiten Anschluß (31) eine Reihenschaltung aus einem vierten (33) und einem fünften Kondensator (34) enthält und einen dritten ohmschen Widerstand (36) umfaßt, der einen Verbindungspunkt (35) zwischen dem vierten (33) und fünften Kondensator (34) mit dem dritten Anschluß (32) des zweiten Netzwerks (29) verbindet.

9. Schaltungsanordnung nach einem der vorhergehenden Ansprüche,
gekennzeichnet durch einen dritten Umschalter (41) mit einem Ausgang (42), der mit dem Signalausgang (5) der Schaltungsanordnung verbunden ist, und mit zwei Eingängen (43, 44), die wahlweise mit dem Ausgang (42) verbindbar sind und deren erstem (43) das Signal vom Signaleingang (2) der Schaltungsanordnung und deren zweitem (44) das Signal von der Kerbfilterstufe (3) zuleitbar ist.

10. Schaltungsanordnung nach einem der Ansprüche 2 bis 5 in Verbindung mit Anspruch 9 und einem der Ansprüche 6 bis 8 ,
gekennzeichnet durch eine Steuerschaltung (37) zum voneinander unabhängigen Steuern der Umschalter (11, 28, 41) gemäß einem gewünschten Amplituden-Frequenzgang im Übertragungs-Frequenzbereich.
